# EUROPEAN PATENT APPLICATION

(11) **EP 0 588 481 A1**
(43) Date of publication of application: **23.03.1994**
(21) Application number: 93306166.5
(22) Date of filing: 04.08.1993
(51) Int. Cl.: H01L 23/495

(54) **Bond pad layouts for integrated circuit semiconductor dies and forming methods**

(30) Priority: 17.08.1992 US 931185
(71) Applicant: AMERICAN MICROSYSTEMS, INCORPORATED, Pocatello, ID 83201 (US)
(72) Inventor: Cusack, Michael D., Pocatello, Idaho 83201 (US); Holloway, Jeffrey G., Pocatello, Idaho 83201 (US); Park, Jonathan C., Pocatello, Idaho 83201 (US); Ashton, Darrel V., Pocatello, Idaho 83201 (US); Jacobson, Evelyn L., Pocatello, Idaho 83201 (US); Wright, John A., Pocatello, Idaho 83201 (US)
(74) Representative: Pilch, Adam John Michael

(57) **Abstract**

s7 An integrated circuit bond pad layout for use with radially bonded leadframes reduces the effective bond pad pitch, allowing smaller semiconductor dies to be used for a given integrated circuit package. One specific bond pad layout results in an effective bond pad pitch that is 80% of the minimum bond pad pitch otherwise achievable. Two rows (707,708) of bond pads (704) are located around the periphery of the semiconductor die (701). The bond pad pitch on one row (707) is different from that of the other row (708). In one embodiment, the bond pad pitch on one row (707) is constant and on the other row (708) is variable. The different bond pad pitches on each row allow the spacing between adjacent bond wires (706) to be maintained approximately constant, thus avoiding interference between adjacent bond wires (706) or between bond wires and wirebonder equipment during the bonding process. The resulting bond pad layouts are dependent only on lead count. Thus, a given layout may be used with any radially bonded leadframe having the same lead count for which the layout is designed.

## Description

This invention relates to bond pad layouts on semiconductor dies on which integrated circuits are to be formed, such as bond pad layouts for use with radially bonded leadframes.

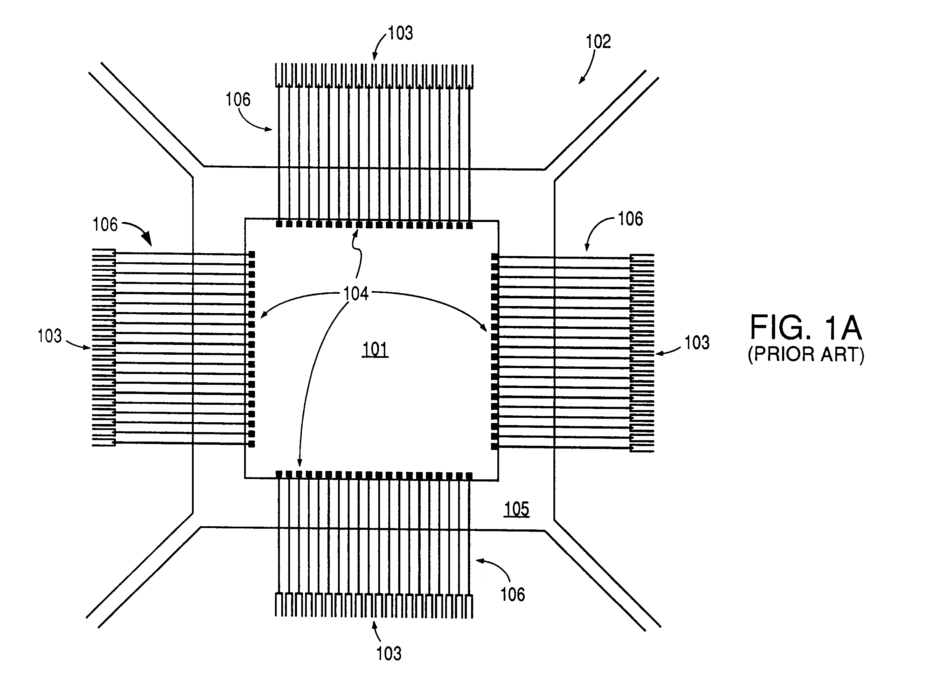

FIG. 1A of the accompanying drawings shows a plan view of a previously proposed semiconductor die 101 mounted on the die attach pad 105 of a leadframe 102. An integrated circuit (not shown) is formed on the die 101. The leadframe 102 includes leads 103 that are arranged orthogonally with respect to the sides of the die 101 (i.e., the leadframe 102 is an "orthogonally bonded leadframe"). Bond pads 104 are formed on the die 101 and are arranged in four single row groups around the periphery of the die 101. Each of the four rows is parallel to the corresponding side of the die 101.

Inputs to and outputs from the integrated circuit need to be transmitted between the die 101 and other electronic components. This is done by connecting the electrically conductive leads 103 to the bond pads 104 with electrically conductive bond wires 106. The bond pads 104 represent input or output points from the integrated circuit. Signals are transmitted to or from these pads 104 through the bond wires 106 and leads 103 from or to electronic components outside an integrated circuit package formed by encasing the die 101, bond wires 104 and inner portions of the leads 103 in, for instance, a plastic encapsulant.

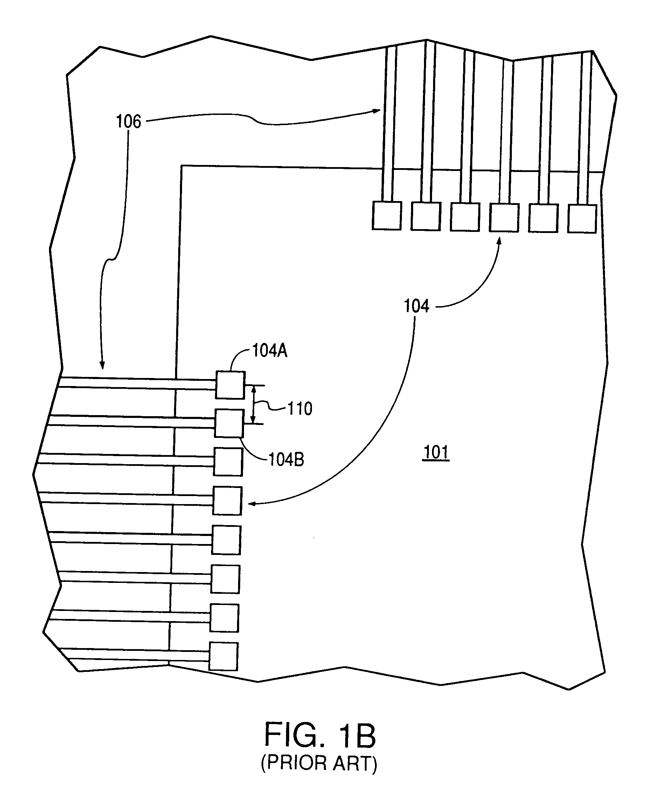

FIG. 1B is a magnified view of a corner section of the semiconductor die 101 shown in FIG. 1A. The single row bond pad layout shown is typical of the layouts used for an orthogonally bonded leadframe. The distance 110 between bond pads 104 (bond pad pitch) is measured from the center of one pad, e.g., 104A to the center of an adjacent pad, e.g., 104B. A typical bond pad pitch 110 is 5 mils (0.13 mm).

It is desirable to minimize the size of a semiconductor die. Two limitations on die size are the number of bond pads and the bond pad pitch. The number of connections which must be made outside the integrated circuit package defines the minimum number of bond pads that must be placed on the die. Thus, within the limitations imposed by the integrated circuit package design (i.e., the number of external connections and, thus, minimum number of bond pads), it is desirable to minimize die size by minimizing bond pad pitch.

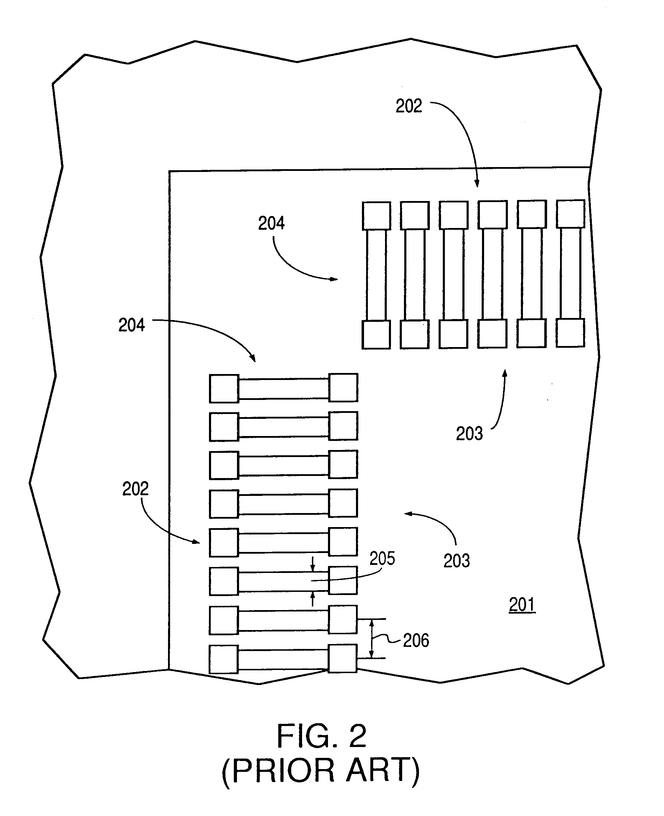

Integrated circuit design dictates the minimum bond pad pitch that may be used. FIG. 2 shows a corner section of a semiconductor die 201. For each bond pad 202 there is an associated buffer 203 between the bond pad 202 and the integrated circuit (not shown). Each of the buffers 203 is connected to a bond pad 202 by a metal trace 204. Since adjacent metal traces may not contact each other, the width 205 of these metal traces 204 sets a lower limit on the achievable bond pad pitch 206 fora particulardie having a particular integrated circuit design. For the single row bond pad layout shown in Figure 2, the bond pad pitch 206 must be slightly greater than the width 205 of the metal traces 204.

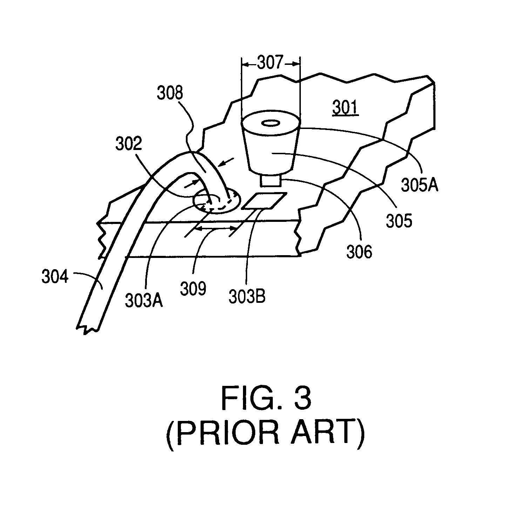

Additionally, a given integrated circuit package requires use of particular wirebonder equipment. As described below with respect to FIG. 3, the wirebonder equipment used in attaching bonding wires between the pads and the leadframe leads imposes a physical limitation on the spacing between pads. In this way too, package design sets a lower limit on bond pad pitch, albeit indirectly.

FIG. 3 illustrates the use of wirebonder equipment to attach bond pads to leads of a leadframe. A section of a semiconductor die 301 is shown. A ball bond 302 has been formed on a bond pad 303A and a bond wire 304 extends from the ball bond 302 to a lead (not shown) of a leadframe. A capillary 305, formed as a truncated cone having a large diameter end 305A, is shown disposed over a pad 303B. Bonding wire 306 is being fed from the capillary 305 to form another ball bond on the pad 303B. During the formation of the ball bond on pad 303B, the capillary 305 (particularly the large diameter end 305A) may undesirably contact the bond wire 304 if the combination of the diameter 307 of the large diameter end 305A and the diameter 308 of the bond wire 304 is sufficiently large compared to the bond pad pitch 309.

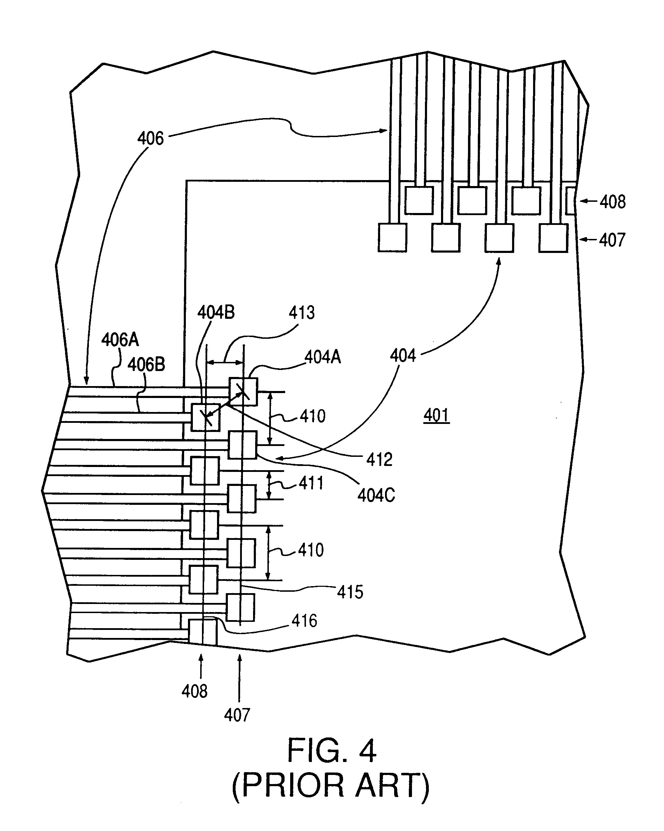

One way to reduce the effective bond pad pitch of pad layouts used with orthogonally bonded leadframes, while conforming to the limitations on actual bond pad pitch described above, is to place the pads in two rows in a configuration known as "straight staggered." FIG. 4 shows a plan view of a corner of a semiconductor die 401 with bond pads 404 arranged in a straight staggered configuration. In this layout, four two-row groups of bond pads 404 are located around the periphery of the die 401. Each of the four groups has an inner and outer row of bond pads 407 and 408, respectively, the center points of the pads on each row 407 or408 defining lines 415 and 416, respectively, which are parallel to the corresponding side of the die 401. The pads in inner rows 407 are offset from the pads in outer rows 408 so that, measured along the length of the side of the die, the center points of pads in inner rows 407 tie halfway between the center points of pads in outer rows 408.

For a given row (either 407 or 408), the actual bond pad pitch 410 is the same or greater than the bond pad pitch 110 of the pads 104 in FIG. 1 B. However, the effective bond pad pitch 411 of the pads 404 in FIG. 4 is one half of the actual bond pad pitch 410 since twice as many bond pads 404 are now disposed along the same length. As compared to the single row bond pad layout of FIGS. 1Aand 1B, the straight staggered bond pad layout allows the bond pad density to be approximately doubled and decreases the effective bond pad pitch 411, the amount of the decrease depending on the actual bond pad pitch 410 used along the bond pad rows 407 and 408.

In the straight staggered bond pad layout, the effective bond pad pitch 411 is decreased while interference between the wirebonder equipment and bond wires during the wire bonding process is avoided. This occurs because the staggering of the rows 407 and 408 allows maintenance of adequate distance between each pad, e.g., 404Aand the closest surrounding pads, e.g., 404B, 404C. The distance between inner row pads 404A and 404C is the aforementioned actual bond pad pitch 410 which, as noted above, is greater than or equal to the bond pad pitch 110 of the single row bond pad layout of FIGS. 1A and 1 B. The distance 412 between inner row pad 404Aand outer row pad 404B is also, by selecting an adequate distance 413 between the lines 415 and 416, sufficiently large to avoid interference between the wirebonder equipment and adjacent bond wires. Further, interference between adjacent bond wires, e.g., 406A, 406B does not occur despite the increased number of bond wires 406 per unit length along the side of the die 401 because the diameter of the bond wires 406 is sufficiently small.

It is also desirable to minimize the size of the overall integrated circuit package. One way to do this is to reduce the size of the leadframe for a given number of leads, or, in other words, maximize the number of leads for a given size leadframe. To this end, leadframes with leads extending radially inward toward the center of the die (i.e., the leadframe is a "radially bonded leadframe"), rather than orthogonally to the side of the die, have been utilized so that space is not wasted at the corners of the leadframe.

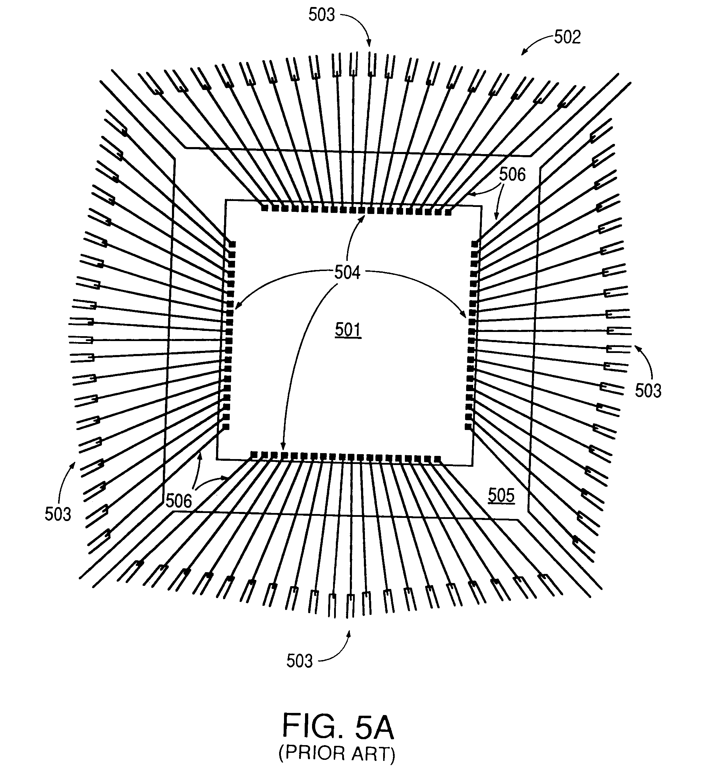

FIG. 5A shows a plan view of a semiconductor die 501 mounted on the die attach pad 505 of a radially bonded leadframe 502. The leadframe 502 includes leads 503 that are arranged radially with respect to the center of the die 501. Bond pads 504 are formed on the die 501 in a sinale row bond pad layout as in FIGS. 1Aand 1 B. Bond wires 506 connect each of the leads 503 to a selected bond pad 504.

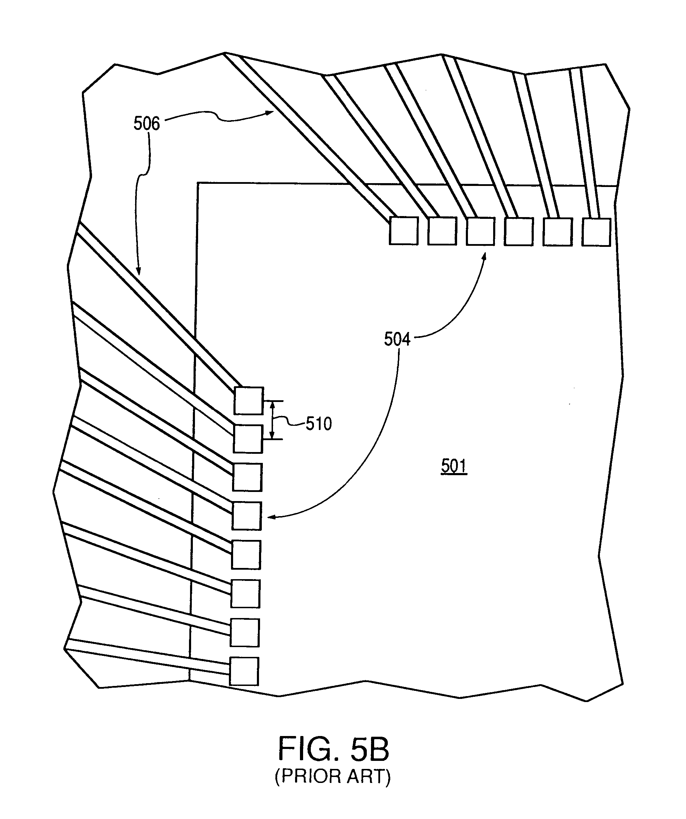

FIG. 5B is a magnified view of a corner section of the semiconductor die 501 shown in FIG. 5A. As can be seen in FIGS. 5Aand 5B, the single row bond pad layout shown in FIGS. 1Aand 1B may equally well be used for a radially bonded leadframe. However, the same limitations on the bond pad pitch 510 apply as for orthogonally bonded leadframes. Thus, die size is not decreased by using a radially bonded leadframe with a single row bond pad layout, since the minimum bond pad pitch is the same as for an orthogonally bonded leadframe.

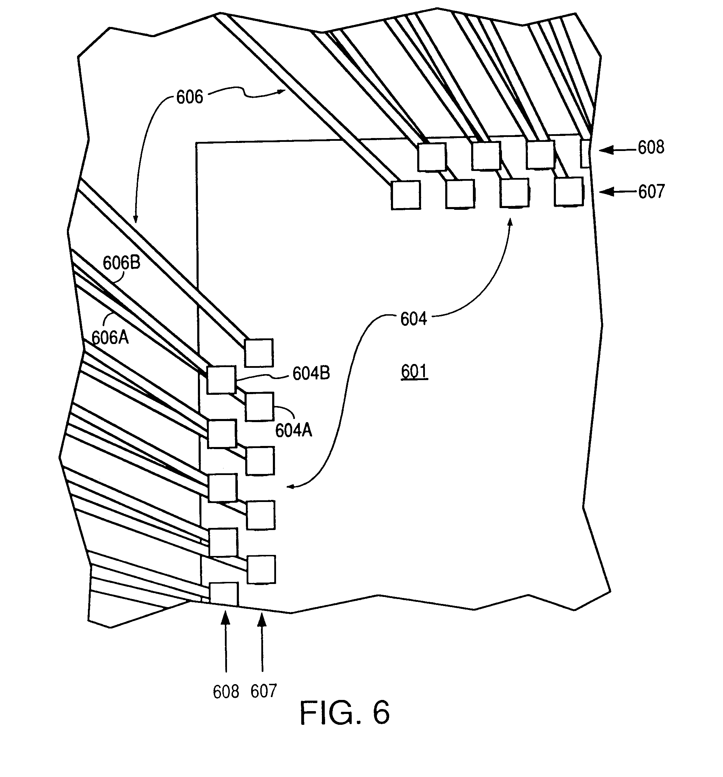

Further, use of the straight staggered layout is not possible for radially bonded leadframes since, as shown in FIG. 6, interference between certain pairs of adjacent bond wires, e.g., 606A, 606B occurs at the corners of the die 601. This happens because the bond wires 606 at the corners are oriented at an approximately 45° angle with respect to the corresponding side of the die 601, rather than being perpendicular as for an orthogonally bonded leadframe, so that certain sets of pads, e.g., 604A, 604B in the two rows of pads 607, 608 are, in effect, placed nearly directly behind each other.

Consequently, there is a need for a bond pad layout for use with radially bonded leadframes that reduces effective bond pad pitch while avoiding interference between adjacent bond wires.

According to the invention, a bond pad layout for a radially bonded leadframe is described which reduces effective bond pad pitch. Inner and outer rows of bond pads are located around the periphery of a semiconductor die, one inner and one outer row adjacent each of one or more sides of the die. Each inner and outer row of bond pads is parallel to the corresponding side of the die. The inner row has a bond pad pitch that is different than the bond pad pitch of the outer row. In one embodiment, the bond pad pitch on either the inner or outer row is constant while the bond pad pitch on the other row is variable. As a consequence of the difference in bond pad pitch between the inner and outer rows, the position of inner row pads relative to the position of outer row pads changes from the center of the die to the corners of the die.

As a result of this changing relative position between inner and outerrow pads, the spacing between adjacent bond wires is maintained approximately constant. Therefore, bond wire interference is avoided. At the same time, effective bond pad pitch is decreased beyond that which would be possible using a single row of bond pads. The bond pad layout according to one embodiment of the invention results in an effective bond pad pitch that is 80% of the minimum bond pad pitch that is otherwise achievable. Thus, the bond pad layout according to the invention provides the benefits of minimum bond pad pitch associated with having two rows of bond pads, while avoiding the problem of bond wire interference that arises with a two row, straight staggered arrangement.

Bond pad layouts according to the invention are dependent only on lead count. Thus, a given layout may be used with any radially bonded leadframe having the same lead count for which the layout is designed.

Since, according to one embodiment of the invention, the location of the inner row of pads is taken as given, the method for determining bond pad layout according to the invention may be used with existing die designs having particular macro locations which define the location of the inner row of pads. For a given location of inner row pads, the method according to the invention is tailored to locate the outer row of pads to minimize effective bond pad pitch while avoiding bond wire interference. The minimization of effective bond pad pitch allows reduced die size which reduces cost of production of the integrated circuit chip, increases chip reliability and increases chip performance. Alternatively, an increased number of bond pads may be utilized for given die size, thereby providing more pads on the die than could be achieved with prior art layouts.

The bond pads in the bond pad layout according to the invention may have any shape (e.g., rectangular, circular). In a preferred embodiment according to the invention, the bond pads are octagonal in shape. This bond pad shape allows easy verification of clearance between bond wires and bond pads in the finished package.

The bond pad layout according to the invention is also adjustable for use with orthogonal bonding by adjusting only three programmable levels. The bond pad layout is also good for both two metal and three metal applications.

Respective aspects of the invention are set forth in claims 1, 11, 20, 21 and 22.

The invention will now be described by way of example with reference to the accompanying drawings, throughout which like parts are referred to by like references, and in which:
FIG. 1A is a plan view of a semiconductor die and leadframe in which the leads are arranged orthogonally to the die and the bond pads are arranged in a standard single row configuration;
FIG. 1B is a magnified view of a section of the plan view of FIG. 1A showing the bond pads and bond wires at one corner of the semiconductor die;
FIG. 2 is a plan view of a corner section of a semiconductor die illustrating how integrated circuit design affects minimum bond pad pitch;
FIG. 3 illustrates the use of wirebonder equipment to attach bond pads to leads of a leadframe;
FIG. 4 is a plan view of a corner of a semiconductor die showing bond pads and bond wires placed in a straight staggered arrangement for use with an orthogonally bonded leadframe;
FIG. 5A is a plan view of a die and leadframe in which the leads are arranged radially with respect to the center of the die and the bond pads are arranged in a standard single row configuration;
FIG. 5B is a magnified view of a section of the plan view of FIG. 5A showing the bond pads and bond wires at one corner of the semiconductor die;
FIG. 6 is a plan view of a corner of a semiconductor die showing bond pads and bond wires placed in a straight staggered arrangement for use with a radially bonded leadframe;
FIG. 7A is a plan view of a die and leadframe in which the leads are arranged radially with respect to the die and the bond pads are arranged according to an embodiment of the invention;
FIG. 7B is a magnified view of a section of the plan view of FIG. 7A showing the bond pads and bond wires at one corner of the semiconductor die; and
FIG. 8 shows graphically how bond pad locations are determined according to an embodiment of the invention.

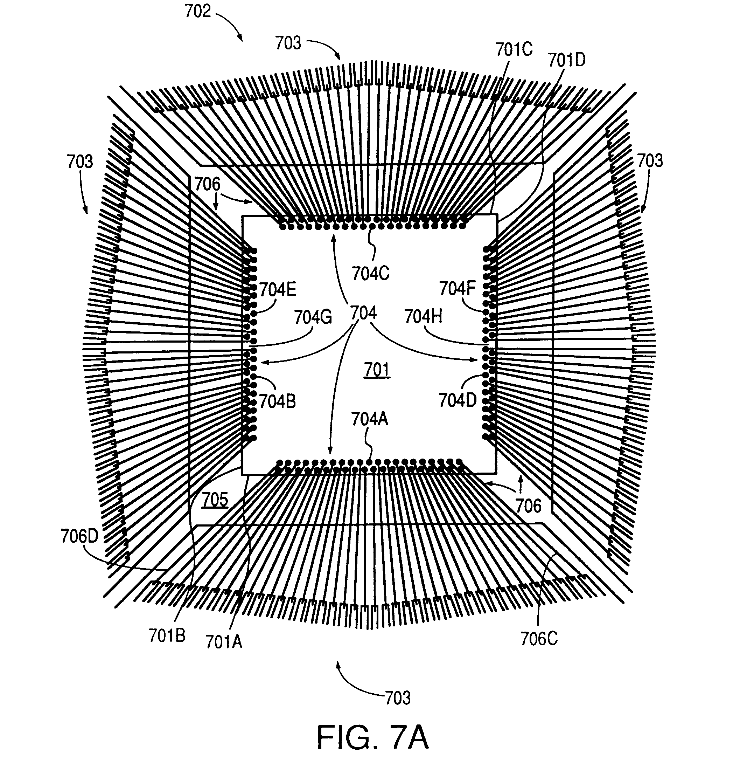

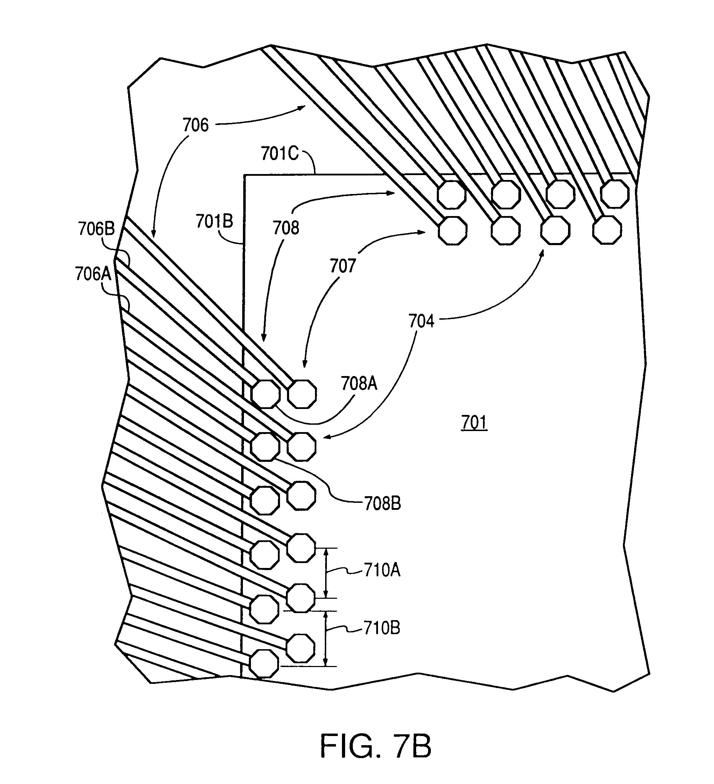

FIG. 7Ashows a plan view of a semiconductor die 701 mounted on the die attach pad 705 of a leadframe 702. An integrated circuit (not shown) is formed on the die 701. The leads 703 of the leadframe 702 are arranged radially with respect to the center of the die 701. Four two-row groups of bond pads 704 are arranged around the periphery of the die 701 according to an embodiment of the invention. Each of the four groups has an inner and outer row of bond pads 707 and 708, respectively, the center points of the pads on each inner and outer row 707 or 708 defining a line parallel to the corresponding side of the die 701. Bond wires 706 connect each of the bond pads 704 to one of the leads 703.

The bond pad layout shown is for a leadframe with 160 leads. It is to be understood that bond pad layouts according to the invention can be provided for leadframes with other lead counts using the method described below.

Further, it is to be understood that the radially bonded leadframe shown is merely illustrative. The invention is broadly applicable to any radially bonded leadframe, i.e., a leadframe in which the bond wires extend from an inner portion of the leads toward the center of the die. For example, a radially bonded leadframe for which a bond pad layout according to the invention could be used may have leads that are orthogonal with respect to the side of the die, some of the leads having inner portions located beyond the corner of the die (in a direction parallel to a die side and orthogonal to the corresponding leads) such that bond wires extend from each of the leads toward the center of the die.

FIG. 7B is a magnified view of a section of the plan view of FIG. 7Ashowing the bond pads 704 and bond wires 706 at one corner of the semiconductor die 701. The effective bond pad pitch (i.e., the equivalent single row bond pad pitch that would correspond to the integrated circuit buffers) is reduced as compared to the bond pad pitch 510 of the radial bonding configuration shown in FIGS. 5A and 5B. Further, the bond wires 706 are generally spaced at equal distances from each other so that there is no interference between any adjacent bond wires, e.g., 706A, 706B, in contrast to the result that would be obtained with the use of the straight staggered configuration shown in FIG. 6. As will be explained in greater detail below, the approximately equal spacing of the bond wires 706 is directly related to the method for locating the bond pads 704 on the die 701.

As can be appreciated from FIG. 7B, the bond pads 704 in the two rows 707 and 708 are offset from each other. However, the offset does not remain constant along the length of a side, e.g., 701 B of the die 701. This is because the outer row bond pad pitch 710B is larger than the inner row bond pad pitch 710A. (The outer row bond pad pitch in this embodiment of the invention is also variable, as will be explained in greater detail below.) In the middle of any side of the die 701, the center point of pads 704 in the outer row 708 is located approximately midway (measured along the length of the side, e.g., 701 B of the die 701) between the center points of two pads 704 in the inner row 707. However, at either end of a die side, e.g., 701 B, the center points of pads 704 in the inner and outer rows 707 and 708 are at approximately the same location. This difference in bond pad pitch between the inner and outer rows 707 and 708 allows two rows of pads 704 to be used without producing interference between bond wires 706.

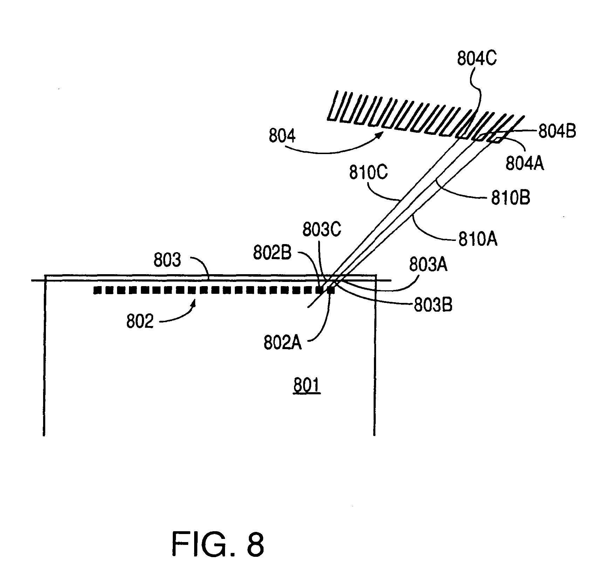

Individual pad positions for the inner and outer rows of pads 707 and 708 may be determined according to the invention by graphical means as shown in FIG. 8. The location of the inner row bond pads 802 is first laid out on the die 801 so that the inner row pad pitch is constant. The inner row pad pitch is selected to be approximately twice the desired effective bond pad pitch.

An outer row pad line 803 is drawn, along which will lie the center points of the pads (not shown) that will comprise the outer row. Lines, e.g., 810A, 810C are drawn from the center point of each inner row pad, e.g., 802A, 802B to the attachment point, e.g., 804A, 804C on the lead 804 to which the inner row pad 802 will be connected. (Generally, an inner row pad 802 is connected to every other one of the leads 804; the remaining leads 804 are connected to outer row pads.) Outer row bond wire lines, e.g., 810B are then drawn from each attachment point, e.g., 804B of a lead 804 to which an outer row pad will be connected such that the lines, e.g., 810B bisect the angle formed by lines 810A, 810C, etc. The intersections, e.g., 803B of each of the outer row bond wire lines, e.g., 81 OB with the outer row pad line 803 define the locations of the center points of outer row pads.

When the outer row of bond pads is laid out in this way, each bond wire is equidistant from the bond wires on 5 either side. The outer row bond pad pitch is greater than the inner row bond pad pitch and varies along the length of the row. The pad pitch between adjacent outer row pads near the corners of the die is greater than the pitch between adjacent outer row pads near the center of the die.

Alternatively, the outer row bond wire lines, e.g., 810B can be drawn from attachment points, e.g., 804B of leads to which an outer row pad will be connected such that the intersection, e.g., 803B of the outer row bond wire lines, e.g., 810B with the outer row pad line 803 is midway between the points of intersection e.g., 803A, 803C of the outer row pad line 803 with the inner row bond wire lines, e.g., 810A, 810C lying on either side of the outer row bond wire line, e.g., 810B.

When the outer row of bond pads is laid out in this way, each bond wire is approximately, though not exactly, equidistant from the bond wires on either side. The outer row bond pad pitch is greater than the inner row bond pad pitch and, depending on the particular arrangement of leads, may or may not remain constant along the row. Typically, the outer row bond pad pitch increases from the center of the die to the corners of the die.

Both of the methods described above for locating the outer row bond pads result in outer row bond pad locations that, in conjunction with the inner row bond locations, provide a reduction in effective bond pad pitch, maintain adjacent bond wires approximately equidistant from each other, and avoid interference between the wirebonder equipment and bond wires during the wire bonding process.

Though in the above description the inner row pads 802 were laid out first and then the outer row pads were located relative to the inner row pads 802, it will be understood that, alternatively, the outer row pads could have been laid out first. In that case, the inner row pads 802 are then located relative to the outer row pads in a manner analogous to that described above, i.e., an inner row pad line is drawn and inner row pads 802 are located either at the intersection between the inner row pad line and lines bisecting the lines drawn from outer row pads to their corresponding leads, or at a point on the inner row pad line that is midway between lines drawn from outer row pads to their corresponding leads. In embodiments of the invention in which the outer row pads are laid out first, the outer row pad pitch will be constant and the inner row pad pitch will be variable.

It should be noted that in all embodiments of the invention the inner row pad pitch is less than the outer row pad pitch. As noted above with respect to the embodiment of the bond pad layout according to the invention illustrated in FIGS. 7A and 7B, the inner row bond pitch (which is constant in this embodiment) is chosen to be approximately twice the desired effective bond pad pitch. Typically, the desired effective bond pad pitch will be determined by the placement of the buffers on the integrated circuit die. For embodiments of the invention in which the outer row pads are laid outfirst, and recalling that for these embodiments the inner row bond pad pitch will be both variable and less than the outer row bond pad pitch, it is necessary to choose an outer row bond pad pitch that is sufficiently large so that the minimum inner row bond pad pitch will not be small enough to result in an effective bond pad pitch that is smaller than that allowed by the placement of buffers on the integrated circuit die. Selection of an appropriate outer bond pad pitch may require an iterative process in which a number of outer row bond pad pitches are tried.

In the embodiment of the invention shown in FIG. 7A, there are several bond pads, e.g., 704Awhich are unused, i.e., there is no bond wire 706 connecting the pad 704 to a lead 703. On each of sides 701A and 701 C there is a pad 704A and 704C, respectively, in the center of the inner row of pads 707 that is unused. As a consequence, there are adjacent outer row pads 708 having bond wires 706 that extend to adjacent leads 703.

Additionally, on each of sides 701 B and 701 D there are pads, e.g., 704B and 704E near the center of the inner row of pads 707 that are unused. This results, again, in adjacent outer row pads 708 having bond wires 706 that extend to adjacent leads 703. The presence of the unused pads, e.g., 704B and 704E also eliminates the need for a pad 704 at the center, e.g., 704G of the outer row of pads 708 along the sides 701 B and 701 D where a pad might otherwise have been placed.

These characteristics of this embodiment of the invention occur because the number and location of inner row bond pads 707 was fixed by a preexisting die design. The outer row bond pads 708 were located, as described above, based upon the location of the inner row pads 707. The resulting bond pad layout is the one shown in FIG. 7A. While several pads 704 are unused, the layout accomplishes the goal of providing smaller effective bond pad pitch without requiring redesign of the macro placement on the die. It is to be understood that these idiosyncratic characteristics of the embodiment shown are not an intrinsic aspect of the invention, i.e., they are not a necessary consequence of application of the method of the invention, but rather are an incidental consequence of application of the method of the invention within certain preexisting constraints.

Additionally, in the embodiment shown in FIG. 7A, the two outermost bond wires, e.g., 706C and 706D on each side, e.g., 701A of the die 701 extend from an inner row bond pad 707. This, too, is a consequence of the fact that the inner row pad locations were dictated by the integrated circuit design. If, instead, the pad locations were determined simply through use of the above described method for locating outer row pads and a criterion of bond pad row length minimization, this characteristic may not necessarily result. Variation of integrated circuit design parameters may also result in a pad layout that necessitates that the outermost bond wires, e.g., 706C and 706D be attached to outer row pads 708.

The single row bond pad layout of FIG. 5A has a bond pad pitch 510, as shown in FIG. 5B, of 5 mils (0.13 mm). In the embodiment of the invention shown in FIGS. 7Aand 7B, the inner row bond pad pitch 71 OA is 8 mils (0.20 mm). The outer row bond pad pitch 710B is somewhat larger. The effective bond pad pitch (not shown) is 4 mils (0.10 mm). Thus, as compared to the single row bond pad layout of FIG. 5A, the invention achieves a reduction in effective bond pad pitch of 20%, i.e., a reduction from 5 mils (0.13 mm) to 4 mils (0.10 mm).

Note that the inner row bond pad pitch 710Awas chosen to be 8 mils (0.20 mm) to accommodate the output drivers of the existing integrated circuit design, i.e., the 4 mil (0.20 mm) effective bond pad pitch is the minimum that could be used with the output drivers. However, with appropriate changes to the placement of macros, output driver design and package design, a smaller effective bond pad pitch could be used. Based upon the smallest effective bond pad pitch allowed by the integrated circuit design, the inner row bond pad pitch 710A is appropriately reduced below 8 mils (0.20 mm) and 5 the output bond pads are located according to the method described above. Output drivers exist that may utilize an effective bond pad pitch of 2 mils (0.05 mm). The inner row bond pad pitch of 4 mils (0.10 mm) that is required for a 2 mil (0.05 mm) effective bond pad pitch may be achieved by locating macros appropriately and modifying the package design to allow shorter bond wires and smaller bond pads.

Typically, as shown in FIGS. 1 B, 2, 3, 4, 5B and 6, bond pads are formed with a rectangular shape. The invention is broad enough to encompass any pad shape. However, in the preferred embodiment of a bond pad layout according to the invention, the bond pads have an octagonal shape as shown in FIG. 7B.

An octagonal shape is preferred because it aids in ascertaining that there is no contact between bond wires, e.g., 706Aand pads, e.g., 708Aand 708B in the finished integrated circuit package. This is so because an X-ray taken of the package showing the plan view of FIG. 7B should typically show clearance between each bond wire and adjacent bond pads. This would not be so with a rectangular bond pad because bond wires (particularly bond wires extending from pads at the corner of the die) would appear as overlapping the corner of adjacent bond pads even if, in fact, there was no contact between the bond wire and pads (as should be the case) due to the fact that at the location of apparent overlap the bond wire and bond pads were in two different planes along a direction perpendicular to the plane of the die 701 in FIG 7B.

It is to be understood that other shapes having the same utility as the above-described octagonal shape could be used. In general, any bond pad shape may be used in which, in a plan view as in FIG. 7B, a clearance between bond wires and adjacent bond pads would appear.

An embodiment of the invention has been described. The description is intended to be illustrative, not limitative. Thus, it will be apparent to one skilled in the art that certain modifications may be made to the invention as described without departing from the scope of the claims set out below. In particular, it is to be emphasized that the particular bond pad layout shown in FIGS. 7Aand 7B is merely illustrative and reflects considerations other than those inherent in the method for locating bond pads described herein. Bond pad layouts other than the one shown in FIGS. 7A and 7B can be obtained consistent with the description of the invention above.

## Claims

1. A method offorming bond pads on a semiconductor die (701) for an integrated circuit package also including a plurality of electrically conductive leads (706), an inner end of each lead (706) located in proximity to the die (701), the inner ends of the leads (706) arranged radially around the circumference of the die (701), the method comprising the steps of:
forming a first row (707) of bond pads (704) having a first bond pad pitch around the circumference of the die (701); and
forming a second row (708) of bond pads having a second bond pad pitch around the circumference of the die (701).

2. A method according to claim 1, wherein the step of forming a second row of bond pads comprises locating the second row (803) of bond pads such that a first line (810B) drawn from the center point of a bond pad on the second row to a first lead (804B) bisects an angle formed by second and third lines (810A,810C), the second line (810A) drawn from the center point of a bond pad (802A) on the first row to a second lead (804A) and the third line (81 0C) drawn from the center point of a bond pad (802B) on the first row to a third lead (804C) on a side of the first lead (804B) opposite that of the second lead (804A).

3. A method according to claim 1 or claim 2, wherein:
a second row bond pad line (803) connects the center points of the bond pads on the second row; and
the location of the center point of a bond pad (803B) on the second row is midway between the intersection of a first line (810A) and the second row bond pad line (803) and the intersection of a second line (810C) and the second row bond pad line (803), the first line (810A) drawn from the center point of a bond pad (802A) on the first row to a first lead (804A) and the second line (810C) drawn from the center point of a bond pad (802B) on the first row to a second lead (804C).

4. A method according to claim 1, claim 2 or claim 3, wherein the first row of bond pads is an inner row (802) of bond pads and the second row of bond pads is an outer row (803) of bond pads.

5. A method according to claim 1, claim 2 or claim 3, wherein the first row of bond pads is an outer row (803) of bond pads and the second row of bond pads is an inner row (802) of bond pads.

6. A method according to any one of the preceding claims, wherein the first bond pad (707) pitch is constant and the second bond pad (708) pitch is variable.

7. A method according to any one of the preceding claims, wherein an effective bond pad pitch is 0.1 mm.

8. A method according to claim 1, wherein:
first row bond wires (706A) will be used to connect leads to selected ones of the first row bond pads (707) and second row bond wires (706B) will be used to connect leads to selected ones of the second row bond pads (708); and
the step of forming a second row of bond pads (708) comprises locating the second row of bond pads (708) such that each first row bond wire (706A) that has a second row bond wire (706B) lying on either side of and immediately adjacent to the first row bond wire (706A) will bisect the angle formed by the two second row bond wires (706B), and each second row bond wire (706B) that has a first row bond wire (706A) lying on either side of and immediately adjacent to the second row bond wire (706B) will bisect the angle formed by the two first row bond wires (706A).

9. A method according to claim 1, wherein:
bond wires (706) will be used to connect leads (703) to selected ones of the first and second row (707,708) of bond pads (704); and
the step of forming a second row (708) of bond pads (704) comprises locating the second row of bond pads such that the bond wires (706) are equidistant.

10. A method according to any one of the preceding claims, wherein the bond pads (704) are formed in an octagonal shape.

11. A semiconductor die (701) comprising:
a body of semiconductor material, said body including regions which define one or more circuit elements;
a first row (707) of bond pads (704) formed around the circumference of the body of semiconductor material and having a first bond pad pitch;
a second row (708) of bond pads (704) formed around the circumference of the body of semiconductor material and having a second bond pad pitch.

12. A semiconductor die according to claim 11, wherein the first bond pad pitch is different from the second bond pad pitch.

13. A semiconductor die according to claim 12, wherein the first bond pad pitch is constant and the second bond pad pitch is variable.

14. A semiconductor die according to claim 13, wherein the first row of bond pads is an inner row (707) of bond pads (704) and the second row of bond pads is an outer row (708) of bond pads (704).

15. A semiconductor die according to claim 13, wherein the first row of bond pads is an outer row (708) of bond pads (704) and the second row of bond pads is an inner row (707) of bond pads (704).

16. A semiconductor die according to any one of claims 11 to 15, wherein an effective bond pad pitch is 0.1 mm.

17. A semiconductor die according to any one of claims 11 to 16, wherein:
first row (707) bond wires (706) will be used to connect leads (703) to selected ones of the bond pads (704) on the first row (707); and
second row (708) bond wires (706) will be used to connect leads (703) to selected ones of the bond pads (704) on the second row (708), such that each first row bond wire (706A) that has a second row bond wire (706B) lying on either side of and immediately adjacent to the first row bond wire (706A) will bisect the angle formed by the two second row bond wires (706B), and each second row bond wire (706B) that has a first row bond wire (706A) lying on either side of and immediately adjacent to the second row bond wire (706B) will bisect the angle formed by the two first row bond wires (706A).

18. A semiconductor die according to any one of claims 11 to 16, wherein bond wires (706) will be used to connect leads (703) to selected ones of the first and second row (707,708) bond pads, the first and second row (707,708) bond pads being located such that the bond wires (706) will be equidistant.

19. A semiconductor die according to any one of claims 11 to 18, wherein the bond pads (704) have an octagonal shape.

20. A semiconductor die (701) comprising:
a body of semiconductor material, said body including regions which define one or more circuit elements;
a first row (707) of bond pads (704) formed around the circumference of the body of semiconductor material; and
a second row (708) of bond pads (704) formed around the circumference of the body of semiconductor material; wherein:
the bond pads (704) have an octagonal shape.

21. A bond pad layout for use with an integrated circuit formed on a semiconductor die (701) according to any one of claims 11 to 20.

22. An integrated circuit package comprising a semiconductor die (701) according to any one of claims 11 to 20, a plurality of electrically conductive leads (703), an inner end of each lead (703) located in proximity to the die (701), the inner ends of the leads (703) arranged radially around the circumference of the die (701), and a plurality of bond wires (706) each attaching one of the leads (703) to one of the bond pads (704).
